## Europäisches Patentamt
## European Patent Office
## Office européen des brevets

(19)

(11) Veröffentlichungsnummer: **0 018 520**
**B1**

(12)

# EUROPÄISCHE PATENTSCHRIFT

(45) Veröffentlichungstag der Patentschrift:
**15.02.84**

(51) Int. Cl.³: **H 01 L 21/322,** H 01 L 21/265

(21) Anmeldenummer: **80101924.1**

(22) Anmeldetag: **10.04.80**

(54) **Verfahren zur vollständigen Ausheilung von Gitterdefekten in durch Ionenimplantation von Phosphor erzeugten N-leitenden Zonen einer Siliciumhalbleitervorrichtung und zugehörige Siliciumhalbleitervorrichtung.**

(30) Priorität: **30.04.79 DE 2917455**

(43) Veröffentlichungstag der Anmeldung:
**12.11.80 Patentblatt 80/23**

(45) Bekanntmachung des Hinweises auf die Patenterteilung:
**15.02.84 Patentblatt 84/7**

(84) Benannte Vertragsstaaten:
**DE FR GB**

(73) Patentinhaber: **International Business Machines Corporation, Old Orchard Road, Armonk, N.Y. 10504 (US)**

(72) Erfinder: **Schmitt, Alfred, Dr., Schramberger Strasse 45, D-7030 Böblingen (DE)**
Erfinder: **Schorer, Gerd, Dr., Carl-Orffweg 50, D-7033 Herrenberg (DE)**

(74) Vertreter: **Kreidler, Eva-Maria, Dr. rer. nat., Schönaicher Strasse 220, D-7030 Böblingen (DE)**

(56) Entgegenhaltungen:
FR - A - 2 356 277
US - A - 3 852 119
US - A - 4 118 250
US - A - 4 135 292
US - A - 4 144 100

PATENT ABSTRACTS OF JAPAN, Band 2, Nr. 141, 22. November 1978, Tokyo, JP
PATENT ABSTRACTS OF JAPAN, Band 2, Nr. 124, 18. Oktober 1978, Tokyo, JP
NEUES AUS DER TECHNIK, Jahrgang 1978, Nr. 3, 15. Juni 1978, Würzburg, DE, "Herstellung bipolarer integrierter Schaltungen ohne Epitaxie", Zusammenfassung Nr. 465
IBM TECHNICAL DISCLOSURE BULLETIN, Band 19, Nr. 11, April 1977, New York, US, J.B. DINKLAGE et al.:

(56) Entgegenhaltungen: (Fortsetzung)
"Gettering by ion implantation", Seite 4091
JOURNAL OF THE ELECTRO CHEMICAL SOCIETY, Band 126, August 1979, New York, US, A. SCHMITT et al.: "Damage anneal of phosphorous/antimony double implants in silicon", Seite 367C

Die Akte enthält technische Angaben, die nach dem Eingang der Anmeldung eingereicht wurden und die nicht in dieser Patentschrift enthalten sind.

Verfahren zur vollständigen Ausheilung von Gitterdefekten in durch Ionenimplantation von Phosphor
erzeugten N-leitenden Zonen einer Siliciumhalbleitervorrichtung und zugehörige
Siliciumhalbleitervorrichtung

Die Erfindung betrifft ein Verfahren zur vollständigen Ausheilung von Gitterdefekten in durch Ionenimplantation von Phosphor erzeugten N-leitenden Zonen einer Siliciumhalbleitervorrichtung, bei dem zur Amorphisierung des Siliciums in die gleichen N-leitenden Zonen des Siliciumhalbleitersubstrats zusätzlich Ionen implantiert werden und erst im Anschluss an die Doppelimplantation eine Temperung vorgenommen wird, sowie eine zugehörige Siliciumhalbleitervorrichtung.

Es ist bekannt, dass durch die Einführung leitfähigkeitsbestimmender Verunreinigungen, wie Phosphor oder Bor, in Silicium Gitterversetzungen erzeugt werden. Dadurch werden Leckströme in Halbleitervorrichtungen, insbesondere in integrierten Schaltungen, die aus diesem Material bestehen, stark erhöht. In dem Artikel «Strain Compensation in Silicon by Diffused Impurities» von T.H. Yeh at al., J. Electrochem. Soc.: Solid State Science, Januar 1969, Seite 73 wird die Einführung von Verunreinigungen in Silicium durch thermische Diffusion behandelt, und es wird festgestellt, dass bei der Diffusion von Bor oder Phosphor, deren Atomradien sich von denen des Siliciums wesentlich unterscheiden, Spannungen erzeugt werden, die Versetzungen hervorrufen. Yeh at al. kamen zu dem Ergebnis, dass Zinn- oder Germaniumatome, deren Atomradien grösser als die des Silicums sind, die Spannungen im Silicium kompensieren können, die durch thermisch eindiffundiertes Bor oder Phosphor, deren Atomradien wesentlich kleiner als die des Siliciums sind, hervorgerufen werden.

Es ist auch bekannt, dass bei der Einführung von leitfähigkeitsbestimmenden Ionen in einer Dosis von grössenordnungsmässig $10^{14}$/cm² und darüber in Silicium durch Ionenimplantation und nachfolgende Temperung Defekte im Kristallgitter gebildet werden. Die Herabsetzung der Dichte dieser Defekte kann durch eine Doppelimplantation und eine anschliessende thermische Behandlung erfolgen. N. Yoshihiro et al. in «High Dose Phosphorus-Germanium Double Implantation in Silicon», Proceedings of the 4th International Conference on Ionimplantation, 1975, Seiten 571 bis 576 stellten fest, dass die Dichte der Defekte reduziert werden kann, wenn in einer Doppelimplantation Phosphor und Germaniumionen in das Silicium eingebracht werden. Die besten Ergebnisse werden erzielt, wenn anschliessend zuerst eine Temperung in feuchtem Sauerstoff bei 800 °C und dann eine solche in Stickstoff bei 1100 °C durchgeführt wird. Aus der Veröffentlichung geht hervor, dass die Germaniumdosis mindestens 25% der Phosphordosis betragen muss.

Nachteilig an dem beschriebenen Verfahren ist, dass Germanium ungüstig für die Ionenimplantation ist, weil, bedingt durch die geringen Isotopenhäufigkeiten, geringe Ionenstromdichten erhalten werden und dieser Effekt besonders dann ins Gewicht fällt, wenn Germanium in den zuvor genannten hohen Dosen eingesetzt wird. Die Doppeltemperung stellt einen komplizierten Prozess dar, und die im ersten Schritt durchgeführte Oxidation kann andere Gebiete des Halbleiterbauelements nachteilig beeinflussen. Die im zweiten Schritt angewendete hohe Temperatur von 1100 °C ist nachteilig wegen der gleichzeitig stattfindenden Diffusion des Phosphors, weil die Kontrolle des Ionenprofils bei diesen Temperaturen nicht mehr durch die Ionenimplantationsparameter, sondern ausschliesslich durch Diffusionsvorgänge bestimmt wird.

Es ist auch bekannt (deutsche Offenlegungsschrift 2 752 439), dass bei der Ionenimplantation von Arsen in Silicium trotz der sehr ähnlichen Atomradien von Arsen und Silicium Versetzungen im Kristallgitter erzeugt werden und dass diese Versetzungen durch eine Implantation von Germanium in das arsendotierte Silicium wesentlich reduziert werden können.

Zusammenfassend kann gesagt werden, dass es bekannt ist, dass die Dichte der Defekte in mit Arsen oder Phosphor dotierten Gebieten des Siliciums, die während der Diffusion oder Implantation der leitfähigkeitsbestimmenden Ionen entstehen, durch eine Implantation von nichtleitfähigkeitsbestimmenden Ionen, beispielsweise von Zinn oder Germanium, und nachfolgende Temperung herabgesetzt werden kann. Die nichtleitfähigkeitsbestimmenden Ionen müssen jedoch in relativ hohen Konzentrationen eingeführt werden, damit ein Kristallgitterausgleich und eine Herabsetzung der resultierenden Gitterspannungen erfolgt.

Aus der Patentschrift 4 144 100 ist ein Verfahren zur Implantation von Phosphor mit niedriger Dosis unter $5 \cdot 10^{15}$ Ionen/cm² in [100]p-dotiertes Silicium bekannt. Gemäss dieser Patentschrift werden in die gleichen Gebiete, in die Phosphor implantiert wird, Fluor-, Chlor- oder Siliciumionen mit einer Dosis implantiert, die ausreichend ist, um den [100]- Siliciumeinkristall hinreichend zu schädigen. Diese Schädigung ermöglicht eine Temperung in stark oxidierender Atmosphäre, bei der gleichzeitig eine Oxidpassivierung stattfinden kann. Nach diesen Verfahren können mit Oxid passivierte PN-Übergänge erhalten werden, deren Leckstromverhalten genau so niedrig ist wie bei einer Temperung in anderer Atmosphäre oder einer Implantation in [111]-Silicium.

Nachteilig an diesem Verfahren ist, dass selbst durch die Implantation hoher Dosen von Halogen- oder Siliciumionen bei der nachfolgenden Temperung keine vollständige Ausheilung der durch die Phosphorimplantation verursachten Gitterdefekte herbeigeführt werden kann. Dies ist wahrscheinlich darauf zurückzuführen, dass bei der Implantation dieser Ionen in den angegebenen Dosen die Löslichkeitsgrenze für Halogen- oder Silicium im Kristall überschritten wird und daher keine vollständige Amorphisierung des Kristallgitters stattfindet.

Aufgabe der Erfindung ist die vollständige Beseitigung von Gitterdefekten in mit Phosphor dotierten Gebieten des Siliciums, die die Wirkung integrierter Schaltungen sehr nachteilig beeinflussen.

Die Aufgabe der Erfindung wird gelöst durch ein Verfahren der eingangs genannten Art, das dadurch gekennzeichnet ist, dass die Phosphorimplantation mit einer Dosis bis zu $1 \times 10^{16}$ Ionen/cm² vorgenommen wird, die zusätzlich implantierten Ionen leitfähigkeitsbestimmende Ionen mit einer Atommasse grösser als 30 sind, die eine ausreichende Löslichkeit im Siliciumgitter aufweisen und die mit gleicher oder grösserer Eindringtiefe als Phosphor implantiert werden, und dass das Siliciumhalbleitersubstrat in Inertgasatmosphäre bei Temperaturen bis zu 1100 °C getempert wird.

Überraschenderweise wurde festgestellt, dass durch eine Doppelimplantation von Antimon oder Arsen in eine geeignete Implantationstiefe in mit Phosphor implantierte Zonen und eine nachfolgende Temperung die während der Implantation erzeugten Defekte in Silicium vollständig ausgeheilt werden können, sogar wenn Phosphordosen bis zu $5 \times 10^{15}$/cm² angewendet werden. Es wurde ursprünglich angenommen, dass diese Doppelimplantation ebenfalls durch eine Reduktion der Gitterspannungen wirksam wird. Aber dies erscheint nunmehr weniger wahrscheinlich, weil wegen der Grösse der Atomradien von Antimon (0,136 nm) und Arsen (etwa 0,116 nm) im Vergleich zu Phosphor (0,110 nm) und Silicium (0,117 nm) die Antimon- und Arsendosis etwa 40% der Phosphordosis betragen müsste, um Gitterspannungen auszugleichen – erfindungsgemäss ist aber schon eine Antimon- oder Arsendosis von 1- bis 10% der Phosphordosis für die vollständige Beseitigung der Gitterdefekte ausreichend. Normalerweise ist zum Ausgleich der Gitterspannungen erforderlich, dass Antimon oder Arsen und Phosphor überall in einem geeigneten, zueinander passenden Konzentrationsverhältnis vorhanden sind. Diese Bedingung ist wegen der stark unterschiedlichen Diffusionskoeffizienten während der nachfolgenden Temperung nicht erfüllt, und es hat sich gezeigt, dass dieses auch nicht erforderlich ist.

In der Praxis wird Phosphor als leitfähigkeitsbestimmendes Ion in Silicium häufig benutzt. Phosphor ist wegen seines höheren Diffusionskoeffizienten und seiner hohen Löslichkeit besonders zur Herstellung von Subkollektoranschlüssen, Basis- und Emittergebieten in integrierten Halbleitervorrichtungen besonders geeignet. Eine Dotierung mit Phosphor ist zudem weniger aufwendig als eine Dotierung mit Arsen, die im allgemeinen in Form einer Kapseldiffusion vorgenommen wird. Nachteilig war bisher, dass schon bei relativ niedrigen Implantationsdosen für Phosphor von $5 \times 10^{14}$/cm² zahlreiche Defekte im Siliciumgitter entstehen, die sich auch durch eine nachfolgende Temperung bei etwa 900 bis 1200 °C nicht ausheilen liessen. Bei höheren Implantationsdosen von $5 \times 10^{15}$/cm² bei einer Energie von 50 keV zeigten Transmissionselektronenmikroskop-Aufnahmen – wie zu erwarten war – nach einer 120 Minuten dauernden Temperung bei 1200 °C ebenfalls hohe Defektdichten.

Das erfindungsgemässe Verfahren gestattet die Herstellung von N-dotiertem hochwertigem, defektfreiem Silicium durch Implantation von Phosphor. Hierzu werden vor und/oder nach der Phosphorimplantation Antimon oder Arsen in die gleichen Gebiete implantiert. Wesentlich für die Herstellung defektfreien, phosphorimplantierten Siliciums ist, dass das Silicium vor der auf die Implantation folgenden Temperung ausreichend tief amorphisiert wird. Die Amorphisierung erfolgt durch die Implantation von Antimon oder Arsen, die vorzugsweise auf die gleiche Implantationstiefe oder tiefer als Phosphor in das Siliciumsubstrat implantiert werden. Dadurch wird gewährleistet, dass die durch die Phosphorimplantation verursachten Schäden und auch der überwiegende Teil der Phosphordotierung selbst in dem amorphisierten Gebiet liegen.

Die Amorphisierung des Siliciums selbst durch Implantation anderer Ionen muss so vorgenommen werden, dass das amorphisierte Gebiet, auch wenn keine Phosphorimplantation vorgenommen wurde, bei der nachfolgenden Temperung epitaktisch ausheilt. Dies ist dann der Fall, wenn das zur Amorphisierung verwendete Ion genügend schwer ist, d.h. eine Atommasse von grösser 30, und eine ausreichende Löslichkeit im Siliciumgitter aufweist. Für die Doppelimplantation zusammen mit Phosphor ist deshalb Antimon besonders geeignet, es werden jedoch auch mit Arsen gute Ergebnisse erhalten.

Bei der erfindungsgemässen Doppelimplantation erfolgt die Antimonimplantation beispielsweise mit einer Dosis von $5 \times 10^{13}$ bis $1 \times 10^{15}$ Ionen/cm² und einer Energie von mindestens 100, vorzugsweise 140 keV und darüber. In die gleichen Gebiete wird Phosphor mit einer Dosis bis zu $1 \times 10^{16}$ Ionen/cm² und einer niedrigen Energie von beispielsweise 25 bis 50 keV implantiert. Beide Implantationen werden bei Raumtemperatur durchgeführt. Die Einhaltung einer bestimmten Antimondosis ist unwichtig, sofern das Siliciumsubstrat amorphisiert wird. Die obere Grenze für die Antimondosis wird unter den gewählten Temperungsbedingungen erreicht bei $1 \times 10^{15}$ Ionen/cm², weil bei dieser Dosis die Löslichkeitsgrenze des Antimons in Silicium überschritten wird und es zu Ausscheidungen im Siliciumgitter kommt. Die Implantationsenergie wurde so gewählt, dass das Antimon tiefer als Phosphor in das Silicium implantiert wird. Keine Herabsetzung oder Beseitigung der Defekte wird allerdings erhalten, wenn die Eindringtiefe des Antimons geringer als die des Phosphors ist. Wird anstelle von Antimon Arsen in das Siliciumsubstrat implantiert, so erfolgt diese Implantation mit einer Energie von mindestens 80, vorzugsweise 120 keV und darüber und einer Dosis grösser $2 \times 10^{14}$ Ionen/cm². Alle angegebenen Werte gelten für die Implantation bei Raumtemperatur. Bei der Implantation bei niedrigeren Temperaturen, wie z.B. bei der Temperatur des flüssigen Stickstoffs, sind die minimal erforderlichen Antimon- oder Arsendosen deutlich geringer als oben angegeben.

Im Anschluss an die Doppelimplantation wird eine Temperung bei einer Temperatur grösser 900 °C in Inertgasatomosphäre durchgeführt. Danach wird, wie sich aus mehreren Aufnahmen mit dem Transmissionselektronenmikroskop ergibt, ein völlig defektfreies Silicium erhalten. Bei dieser Temperung wird der Phosphor auf die gewünschte Dotierungstiefe eingetrieben. Bei einer möglichen nachfolgenden Oxidation der getemperten Gebiete wird ein Oxid von höchster Gleichmässigkeit erhalten.

Das erfindungsgemässe Verfahren ist beispielsweise zur Herstellung von NPN- und von PNP-Transistorstrukturen geeignet. Ausführungsbeispiele werden nachfolgend anhand der Figuren 1A bis 1C und 2A bis 2B beschrieben.

Es zeigen:

Figuren 1A bis 1C schematische Querschnittsdarstellungen von Teilen einer integrierten Schaltung (vertikaler NPN-Transistor) in verschiedenen Herstellungsphasen;

Figuren 2A bis 2B schematische Querschnittsdarstellungen von Teilen einer integrierten Schaltung (lateraler PNP-Transistor mit hoher Stromverstärkung), in verschiedenen Herstellungsphasen.

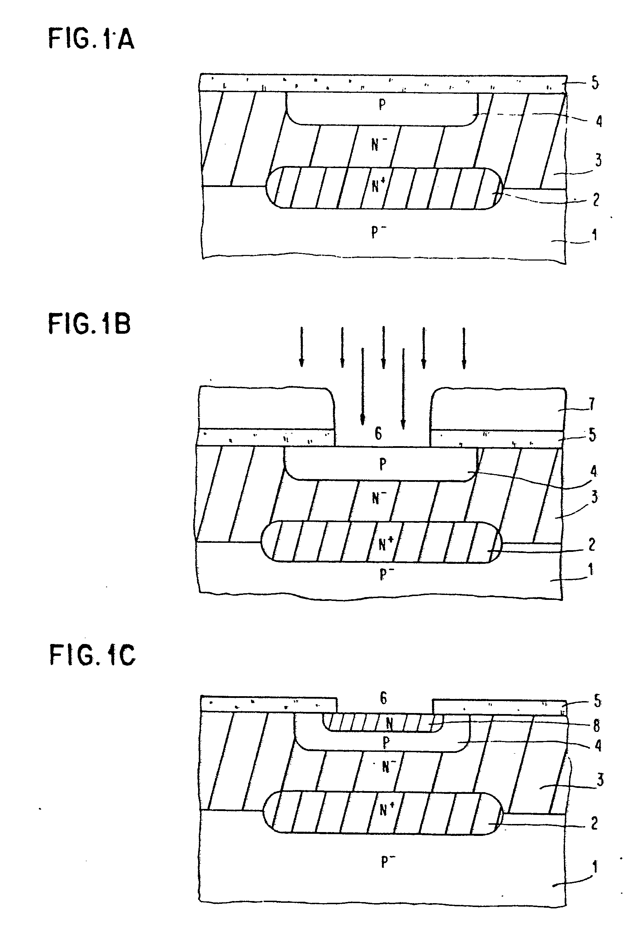

Die zur Herstellung der in Fig. 1A gezeigten Struktur erforderlichen Verfahrensschritte sind konventionell und umfassen Maskierung, Dotierung (Diffusion oder Ionenimplantation) und Beschichtungen. Dabei werden die vergrabene $N^+$-Schicht 2 (Subkollektor), die $N^-$-Epitaxieschicht 3 auf dem Siliciumsubstrat 1, die dotierte Basis 4 des Transistors und eine dielektrische Schicht 5 gebildet. Das Siliciumsubstrat 1 ist vom P-Leitfähigkeitstyp. Die dielektrische Schicht 5, die 50 bis 500 nm dick ist, kann aus Siliciumdioxid bestehen das in bekannter Weise mittels thermischer Oxidation hergestellt wurde. Es kommen auch andere Materialien, wie Siliciumnitrid, Aluminiumoxid oder Siliciumoxynitrid, in Frage, die mittels Kathodenzerstäubung niedergeschlagen oder chemisch aus der Gasphase abgeschieden werden können.

In der dielektrischen Schicht 5 wird in bekannter Weise mittels Photolithographie eine Öffnung 6 erzeugt (Fig. 1B). Durch diese Emitterkontaktöffnung 6 werden, ggf. unter Benutzung einer Photoresistmaske 7, Antimon und Phosphor in die Basis 4 des Transistors implantiert. Die Ionenimplantation kann nach einem Verfahren, das beispielsweise in der deutschen Patentanmeldung P 2 262 024.2 beschrieben ist, durchgeführt werden. Der Ionenstrahl wird für Antimon mit einer Dosis von $1 \times 10^{14}$ Ionen/cm² bei einer Energie von 200 keV und für Phosphor mit einer Dosis von $5 \times 10^{15}$ Ionen/cm² bei einer Energie von 25 keV auf das Substrat gerichtet. Die Energien werden so gewählt, dass die Ionen bis in eine Tiefe von grössenordnungsmässig 100 nm in die Basis 4 eindringen. Anderseits wurde die Implantationsenergie für Antimon so gewählt, dass das Antimon tiefer als Phosphor oder mindestens gleich tief in die Basis 4 implantiert wird.

Im nächsten Schritt wird die Vorrichtung etwa 5 Minuten lang in Sauerstoffatmosphäre und 100 Minuten lang in Stickstoffatmosphäre getempert. Bei dieser Temperung wird der mit Phosphor dotierte Emitter 8 (Fig. 1C) auf die gewünschte Tiefe in die Basis 4 eingetrieben, und gleichzeitig werden Implantationsschäden ausgeheilt.

Damit ist der NPN-Transistor fertiggestellt. Die Gebiete 4 und 8 (Fig. 1C) können natürlich auch separat als P/N-Diode benutzt werden.

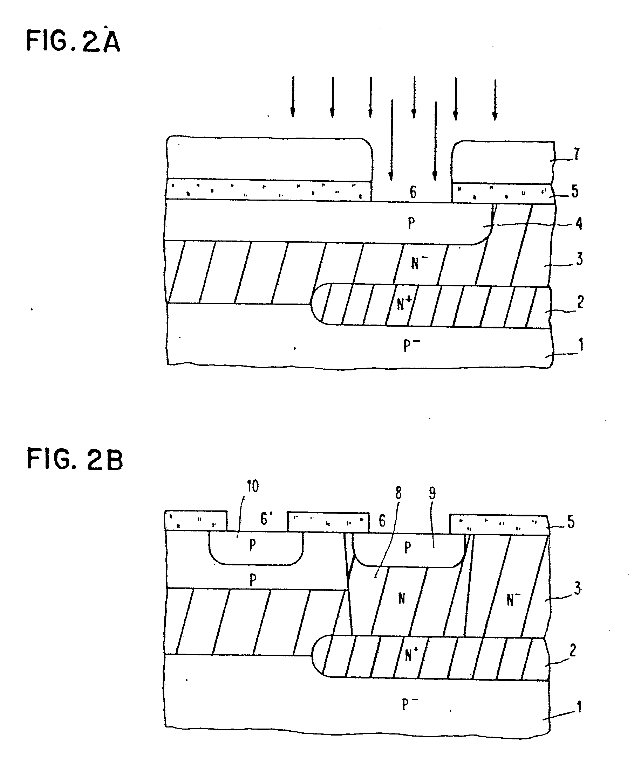

Gemäss den Figuren 2A und 2B kann mit dem erfindungsgemässen Verfahren auch ein PNP-Transistor mit hoher Stromverstärkung hergestellt werden. Mittels konventioneller Verfahren wird eine Struktur aus einer vergrabenen $N^+$-Schicht 2 (Subkollektor) einer $N^-$-Epitaxie 3 auf einem Siliciumsubstrat 1, einem P-dotierten Gebiet 4 und einer dielektrischen Schicht 5 gebildet.

Gemäss Fig. 2A wird in der dielektrischen Schicht 5 mittels Photolithographie die Kontaktöffnung 6 hergestellt. Durch diese Kontaktöffnung werden, ggf. unter Benutzung einer Photoresistmaske 7, Antimon und Phosphor implantiert. Der Ionenstrahl wird für Antimon mit einer Dosis von $1 \times 10^{14}$ Ionen/cm² bei einer Energie von 200 keV und für Phosphor mit einer Dosis von $2 \times 10^{15}$ Ionen/cm² bei einer Energie von 50 keV auf das Substrat gerichtet.

Im nächsten Schritt wird die Vorrichtung etwa 5 Minuten lang in Sauerstoffatmosphäre und 100 Minuten lang in Stickstoffatmosphäre getempert. Dabei wird die mit Phosphor dotierte Basis 8 auf die gewünschte Tiefe eingetrieben, so dass sie den Subkollektor 2 erreicht (Fig. 2B). Schliesslich werden gleichzeitig mittels bekannter Verfahren durch die Kontaktlöcher 6 und 6' P-leitende Zonen, Emitter 9 und Kollektor 10 des lateralen PNP-Transistors diffundiert oder implantiert.

Wenn der Implantationsschritt mit Antimonionen gemäss den Fig. 1B und 2A weggelassen wird, weisen die mit Phosphor dotierten Zonen 8 in den Fig. 1C und 2D eine beträchtliche Anzahl von Defekten im Siliciumkristall auf, die auch durch Temperungsschritte bei Temperaturen bis zu 1100 °C nicht ausgeheilt werden können. Wird jedoch, wie zuvor beschrieben, eine Doppelimplantation von Phosphor und Antimon durchgeführt, so wird nach einer Temperung bei ungefähr 1000 °C in Stickstoffatmosphäre ein vollkommen defektfreier Siliciumkristall erhalten, sogar wenn Phosphor in einer hohen Dosis bis zu $5 \times 10^{15}$ Ionen/cm² implantiert wird. Der Vorteil der Doppelimplantation von Phosphor und Antimon ist aus Transmissionselektronenmikroskop-Aufnahmen und aus elektrischen Messungen die deutlich verminderte Leckströme zeigen, ersichtlich.

Ganz allgemein können durch Phosphorimplantation N-leitende Zonen im Silicum hergestellt werden, welche vollkommen defektfrei sind, wenn, wie in der Erfindung beschrieben ist, eine zusätzliche Implantation von Antimon oder Arsen und anschliessend eine Temperung vorgenommen wird. So können beispielsweise, wie in der europäischen Patentanmeldung 78 100 672.1 anhand von Fig. 1D auf Seite 7 beschrieben ist, durch Implantation von Phosphor und einem nachfolgenden Reoxidationsschritt vollkommen defektfreie N-dotierte Zonen in der dort beschriebenen Halbleitervorrichtung hergestellt werden, wenn vor oder nach der Phosphorimplantation eine Antimon- oder Arsen-Implantation in entsprechende Implantationstiefe durchgeführt wird. Ohne diese Doppelimplantation und anschliessende Temperung wird eine hohe Dichte der Defekte im Silicium erhalten.

## Patentansprüche

1. Verfahren zur vollständigen Ausheilung von Gitterdefekten in durch Ionenimplantation von Phosphor erzeugten N-leitenden Zonen einer Siliciumhalbleitervorrichtung, bei dem zur Amorphisierung des Siliciums in die gleichen N-leitenden Zonen des Siliciumhalbleitersubstrats zusätzlich Ionen implantiert werden und erst im Anschluss an die Doppelimplantation eine Temperung vorgenommen wird, dadurch gekennzeichnet, dass die Phosphorimplantation mit einer Dosis bis zu $1 \times 10^{16}$ Ionen/cm² vorgenommen wird, die zusätzlich implantierten Ionen leitfähigkeitsbestimmende Ionen mit einer Atommasse grösser als 30 sind, die eine ausreichende Löslichkeit im Siliciumgitter aufweisen und die mit gleicher oder grösserer Eindringtiefe als Phosphor implantiert werden, und dass das Siliciumhalbleitersubstrat in Inertgasatmosphäre bei Temperaturen bis zu 1100 °C getempert wird.

2. Verfahren nach Anspruch 1, dadurch gekennzeichnet, dass in die mit Phosphor dotierten Zonen Antimon oder Arsen als zusätzlich leitfähigkeitsbestimmende Ionen vor oder nach der Phosphorimplantation implantiert wird.

3. Verfahren nach den Ansprüchen 1 und 2, dadurch gekennzeichnet, dass in die mit Phosphor dotierten Zonen Antimon oder Arsen in einer Dosis von 1 bis 10% der Phosphordosis implantiert wird.

4. Verfahren nach den Ansprüchen 1 bis 3, dadurch gekennzeichnet, dass die Doppelimplantation nicht bei erhöhter Temperatur durchgeführt wird.

5. Verfahren nach den Ansprüchen 1 bis 4, dadurch gekennzeichnet, dass die Antimon-Implantation mit einer Dosis von $5 \times 10^{13}$ bis $1 \times 10^{15}$ Ionen/cm² und einer Energie von mindestens 100, vorzugsweise 140 keV und darüber und die Phosphorimplantation mit einer Dosis bis zu $1 \times 10^{16}$ Ionen/cm² und einer niedrigen Energie bei Raumtemperatur in das Siliciumhalbleitersubstrat vorgenommen wird.

6. Siliciumhalbleitervorrichtung mit mindestens einer phosphordotierten Zone, hergestellt nach dem Verfahren der Ansprüche 1 bis 5, dadurch gekennzeichnet, dass die mindestens eine phosphordotierte Zone zusätzlich Antimon oder Arsen enthält.

7. Siliciumhalbleitervorrichtung nach Anspruch 6, dadurch gekennzeichnet, dass die Antimon- oder Arsen-Dosis etwa 1 bis 10% der Phosphordosis beträgt.

8. Siliciumhalbleitervorrichtung nach einem der Ansprüche 6 oder 7, dadurch gekennzeichnet, dass die Zone in einer epitaktischen Siliciumschicht angeordnet ist.

## Claims

1. Method of fully eliminating lattice defects in N-conductive zones of a silicon semiconductor device which were generated by ion implantation of phosphorus, where for rendering the silicon amorphous ions are implanted additionally in the same N-conductive zones of the silicon semiconductor substrate, and where tempering takes place only after the double implantation, characterized in that the phosphorus is implanted with a dose of up to $1 \times 10^{16}$ ions/cm², that the additionally implanted ions are conductivity-determining ions with an atomic mass more than 30, which are sufficiently soluble in the silicon lattice, and which are implanted with the same or a greater penetration depth than phosphorus, and that the silicon semiconductor substrate is tempered in an inert gas atmosphere at temperatures of up to 1100 °C.

2. Method as claimed in claim 1, characterized in that into the phosphorus-doped zones antimony or arsenic is implanted as additional conductivity-determining ions prior to and/or after the phosphorus implantation.

3. Method as claimed in any one of claims 1 and 2, characterized in that into the phosphorus-doped zones antimony or arsenic is implanted in a dose of 1 to 10% of the phosphorus dose.

4. Method as claimed in any one of claims 1 to 3, characterized in that the double implantation is not executed at an elevated temperature.

5. Method as claimed in any one of claims 1 to 4, characterized in that the antimony implantation into the silicon semiconductor substrate is effected with a dose of $5 \times 10^{13}$ to $1 \times 10^{15}$ ions/cm² and with an energy of at least 100, preferably 140 keV and more, and the phosphorus implantation with a dose of up to $1 \times 10^{16}$ ions/cm² and with a lower energy at room temperature.

6. Silicon semiconductor device with at least one phosphorus-doped zone made following the method of claims 1 to 5, characterized in that this at least one phosphorus-doped zone additionally contains antimony or arsenic.

7. Silicon semiconductor device as claimed in claim 6, characterized in that the antimony or arsenic dose amounts to approximately 1 to 10% of the phosphorus dose.

8. Silicon semiconductor device as claimed in any one of claims 6 or 7, characterized in that the zone is arranged in an epitaxial silicon layer.

## Revendications

1. Procédé d'élimination des défauts de réseau causés par l'implantation d'ions de phosphore dans des régions de type N d'un dispositif semiconducteur de silicium où on implante des ions supplémentaires afin de rendre amorphe le silicium contenu dans les régions de type N du substrat semiconducteur de silicium et que l'on procède à une opération de recuit qu'une fois la double implantation ionique réalisée, caractérisé en ce que la quantité d'ions de phosphore implantés est au plus égale à $34 \times 10$ ions/cm², que les ions supplémentaires sont des ions déterminant un type de conductivité dont la masse atomique est supérieure à 30, qui permettent une solubilité satisfaisante dans un réseau de silicium et qui sont implantés à une profondeur égale ou supérieure à celle des ions de phosphore, et que le substrat semiconducteur de silicium est recuit dans une atmosphère de gaz inerte à une température allant jusqu'à 1100 °C.

2. Procédé selon la revendication 1, caractérisé en ce qu'on implante, avant ou après l'implantation d'ions au phosphore, dans les régions dopées au phosphore, de l'antimoine ou de l'arsenic comme ions supplémentaires déterminant un type de conductivité.

3. Procédé selon les revendications 1 et 2, caractérisé en ce que la quantité d'ions d'antimoine ou d'arsenic implantés dans les régions dopées au phosphore est comprise 1 et 10% de la quantité d'ions de phosphore.

4. Procédé selon les revendications 1 à 3 caractérisé en ce que la deuxième implantation ionique est réalisée à une température basse.

5. Procédé selon les revendications 1 à 4, caractérisé en ce que la quantité d'ions d'antimoine implantés se situe entre $1 \times 10$ ions/cm² et que l'énergie d'implantation est égale au moins à 100 keV, de préférence à 140 keV et plus, que la quantité d'ions de phosphore implantés est au plus égale á $1 \times 10$ ions/cm² et que l'implantation dans le substrat semiconducteur de silicium est effectuée à la température ambiante avec une énergie faible.

6. Dispositif semiconducteur de silicium comportant au moins une région dopée au phosphore, fabriqué selon le procédé exposé dans les revendications 1 à 5, caractérisé en ce que au moins une des régions dopées au phosphore contient en plus de l'antimoine et de l'arsenic.

7. Dispositif semiconducteur de silicium selon la revendication 6, caractérisé en ce que la quantité d'antimoine ou d'arsenic est comprise entre environ 1 et 10% de la quantité de phosphore.

8. Dispositif semiconducteur de silicium selon une des revendications 6 ou 7, caractérisé en ce que ladite région se trouve dans une couche de silicium épitaxique.

**FIG.1A**

**FIG.1B**

**FIG.1C**

FIG. 2A

FIG. 2B